# EUROPEAN PATENT APPLICATION

(11) **EP 2 806 211 A1**
(43) Date of publication of application: **26.11.2014**
(21) Application number: 14161508.8
(22) Date of filing: 25.03.2014
(51) Int. Cl.: F21V 29/00, F21K 99/00, F21V 7/00

(54) **Solid-state lighting device and related process**

(30) Priority: 21.05.2013 IT TO20130406
(71) Applicant: OSRAM GmbH, 80807 München (DE); Osram S.p.A. - Societa' Riunite Osram Edison Clerici, 20126 Milano (IT)
(72) Inventor: Griffoni, Alessio, I-30030 Fossò (Venezia) (IT); Zanon, Franco, I-36022 Cassola (Vicenza) (IT)
(74) Representative: Bosotti, Luciano

(57) **Abstract**

A solid-state lighting device (10) includes
- a heat sink (12) with a front surface (12a),
- an electrically insulating layer (14) formed on the front surface (12a) of the heat sink (12),
- electrically conductive lines (18) of a reflective material extending over the electrically insulating layer (14),
- one or various solid-state light radiation sources (16), e.g. LED sources, arranged on the electrically insulating layer (14) and provided with anode and cathode terminals, electrically fed via said electrically conductive lines (18), and
- one or various lens formations (20) coupled with said one or various light radiation sources (16) by means of a support member including at least one side wall (22) of a reflective material, electrically insulated from said electrically conductive lines (18) by a further electrically insulating layer (24).

## Description

### Technical field

The present disclosure relates to solid-state lighting devices.

One or various embodiments may refer to lighting devices which make use of LED sources as light radiation sources.

### Technological background

High-brightness solid-state light radiation sources, e.g. LED lighting sources, have currently reached light emission levels which are comparable with incandescent and halogen sources, with a much lower energy consumption. For example, the most recent developments in the technology of high-brightness LEDs have been doubling the luminous output every 18-24 months. Therefore, conventional sources are increasingly replaced by solid-state lighting sources.

The corresponding increase in power dissipation calls for a correct management of the source from a thermal point of view (so-called thermal management). This need is also due to the fact that the maximum level of light emission, the quality, the reliability and the lifetime of such light sources are related to the junction temperature: the management of aspects related to thermal dissipation has therefore become a key point for all solid-state lighting sources.

Factors such as the luminous flux uniformity and/or the features (e.g. the area) of the Light Emitting Surface (LES) may vary from application to application.

For example, street lighting applications and downlight LED modules may require levels of flux uniformity of 5-7 SDCM (Standard Deviation Color Matching), or even 3 SDCM. It is moreover desirable to provide thermal management solutions which may be adapted to different sizes of the Light Emitting Surface (LES).

It is known that the problem of thermal management may be addressed, for example, by attaching packaged LEDs on a board similar to a Printed Circuit Board (PCB), for example a FR4 PCB, or on an Insulated Metal Substrate (IMS), or else on a ceramic board, depending on the requested thermal impedance of the board. It is moreover possible to increase the thermal contact conductance between the board and the corresponding heat sink by using a Thermal Interface Material (TIM). These solutions may be applied rather easily to distributed LESs, while their implementation is more difficult in the case of compact LESs. Moreover, the need to keep costs low influences the achievable level of thermal management.

Another previous solution consists in mounting e.g. Chip-on-Board (CoB) LEDs (i.e. LED chips attached on an IMS PCB or a ceramic board) on a heat sink via a TIM or generally a conductive glue, adapted to improve the properties of thermal conductance between the CoB and the heat sink. Such a solution leads to a better thermal management with compact LESs, while the achievement of distributed LESs may be a challenge.

### Object and Summary

One or various embodiments aim at overcoming the previously outlined drawbacks and constraints.

One or various embodiments achieve this object thanks to a device having the features set forth in the claims that follow. One or various embodiments may also refer to a corresponding process.

The claims are an integral part of the technical teaching of the invention provided herein with reference to the embodiments.

One or various embodiments may be based on thick-film processes, for example with CoB LEDs directly attached to a heat sink, adapted to comprise for example a heat sink of electrically conductive material such as aluminium, or possibly even a board having heat-sink properties.

In one or various embodiments, the LED chip is arranged directly on the heat sink, which guarantees an outstanding level of thermal management while preserving the electrical isolation, and meets safety requirements, while offering a high LES pliability: the result is the possibility to achieve a distributed or uniform luminous flux, depending on the product requirements.

### Brief Description of the Figures

Examples of embodiments will now be described, by way of non-limiting example only, with reference to the enclosed figures, wherein:
- Figure 1 is a sectional view of a lighting device according to embodiments,
- Figure 2, comprising eight parts progressively denoted with letters a) to h), shows steps of a process according to embodiments,
- Figure 3 is a sectional view taken along line III-III of part h) of Figure 2,
- Figure 4 is a sectional view taken along line IV-IV of part h) of Figure 2,
- Figure 5 is a sectional view of a lighting device according to embodiments,
- Figure 6, comprising nine parts progressively denoted with letters a) to i), shows steps of a process according embodiments, and
- Figure 7 is a sectional view taken along line VII-VII of part i) of Figure 6.

### Detailed Description

In the following description, numerous specific details are given to provide a thorough understanding of various exemplary embodiments. One or various embodiments may be practiced without one or several specific details, or with other methods, components, materials, etc. In other instances, well-known structures, materials, or operations are not shown or described in detail to avoid obscuring aspects of the embodiments. Reference throughout this specification to "one embodiment" or "an embodiment" means that a particular feature, structure, or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

The headings provided herein are for convenience only and do not interpret the scope or meaning of the embodiments.

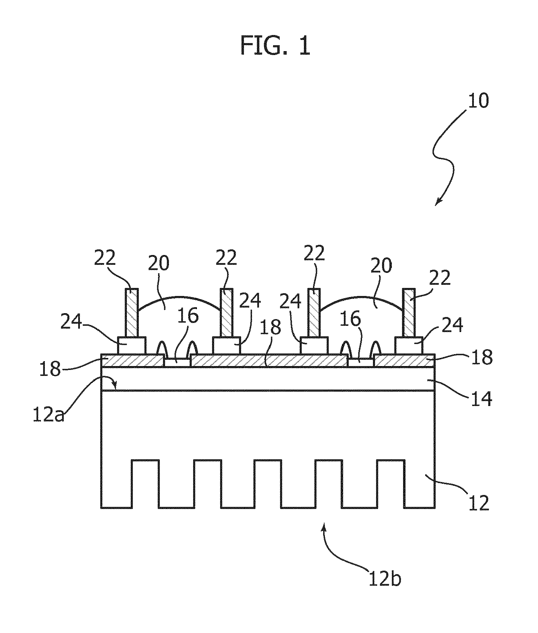

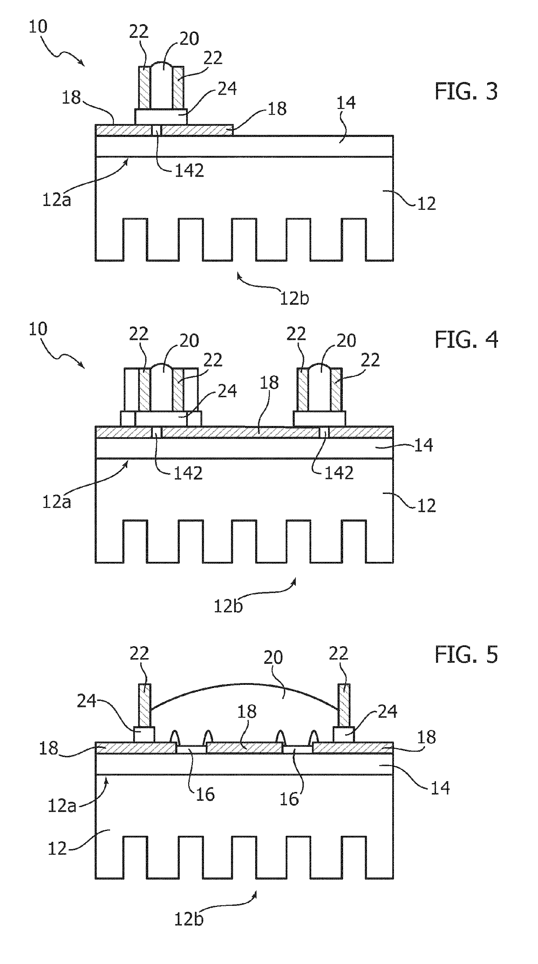

The following description relates to exemplary embodiments of a lighting device 10 comprising a cluster of solid-state light radiation sources, for example CoB LEDs, distributed LEDs (Figures 1 to 4) or compact LEDs (Figures 5 to 7).

It is however to be understood that details and features of implementation, provided herein with reference to embodiments as exemplified in Figures 1 to 4, may be applied to embodiments as exemplified in Figures 5 to 7, and vice versa.

In all figures herein depicted by way of example, the shown parts are deliberately represented not to scale, in order to facilitate understanding.

The embodiments exemplified herein refer to a solid-state lighting device 10 which employs for example, as light radiation sources, CoB LEDs attached to a heat sink 12.

In the illustrated examples, heat sink 12 may be comprised of a heat sink of thermally conductive material (for example aluminium) having a front surface or side 12a and a back surface or side 12b. In one or various embodiments, the back surface may be for example a finned surface. As previously stated, in one or various embodiments the heat-sink function may also be performed by a board, similar to a PCB, for example of the IMS (Insulated Method Substrate) type.

Reference 14 denotes a layer of an electrically insulating material (dielectric), for example a dielectric polymer and/or a glassy polymer.

In one or various embodiments, layer 14 may be applied on the front surface 12a of heat sink 12 via a known thick-film process.

One or various light radiation sources 16 may then be applied on layer 14.

In one or various embodiments, light radiation sources 16 may be solid-state light radiation sources provided with anode and cathode power supply terminals, connected to respective electrically conductive lines 18, respectively anodic and/or cathodic.

In one or various embodiments, lines 18 may comprise a material with high light reflectivity, for example a silver-based material.

In one or various embodiments, lines 18 may be formed using a standard thick-film process.

In one or various embodiments, in association with the light radiation sources 18 there may be provided lenses 20 comprising for example silicone lenses with a phosphorus filler.

In one or various embodiments, as exemplified in Figures 1 to 4, it is possible to associate a respective lens 20 to each light radiation source 16.

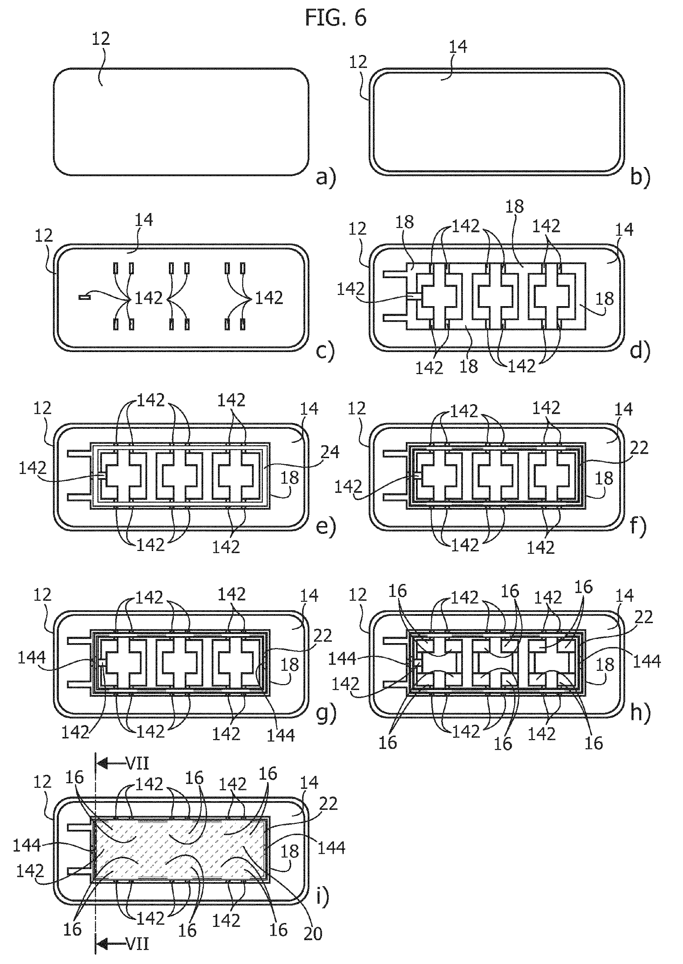

In one or various embodiments, as exemplified in Figures 5 to 7, a single lens 20 may be associated with a plurality of light radiation sources 16: for example (as seen in part i) of Figure 6, which will dealt with in the following) a single lens 20 may be associated with all light radiation sources 16 included in the lighting device 10.

In one or various embodiments, lenses 20 may be kept in place via a support structure.

In one or various embodiments, such a support structure may include side walls 22 of a material having high light reflectivity (for example Ag-based) wrapped around lenses 20.

In one or various embodiments, the walls 22 may extend perpendicularly to the direction of the lying plane of heat sink 12.

In one or various embodiments, the side walls 22 may be electrically isolated from the conductive lines 18 via a further electrically isolating layer 24 (dielectric) adapted to be formed via a thick-film process.

In one or various embodiments, in order to take into account the fact that layer 24 may be formed of a low-reflectivity material, the thickness of layer 24 may be kept at a minimum while ensuring isolation.

In one or various embodiments, the high-reflectivity side walls 22 may be formed in such a way as to be "narrower" (i.e. less "thick") than layer 24 on which the walls are formed; this may be achieved by making walls 22 and layer 24 respectively less thick and thicker, such thickness being measured in the direction of the plane in which heat sink 12 and therefore layers 14 and 17 extend.

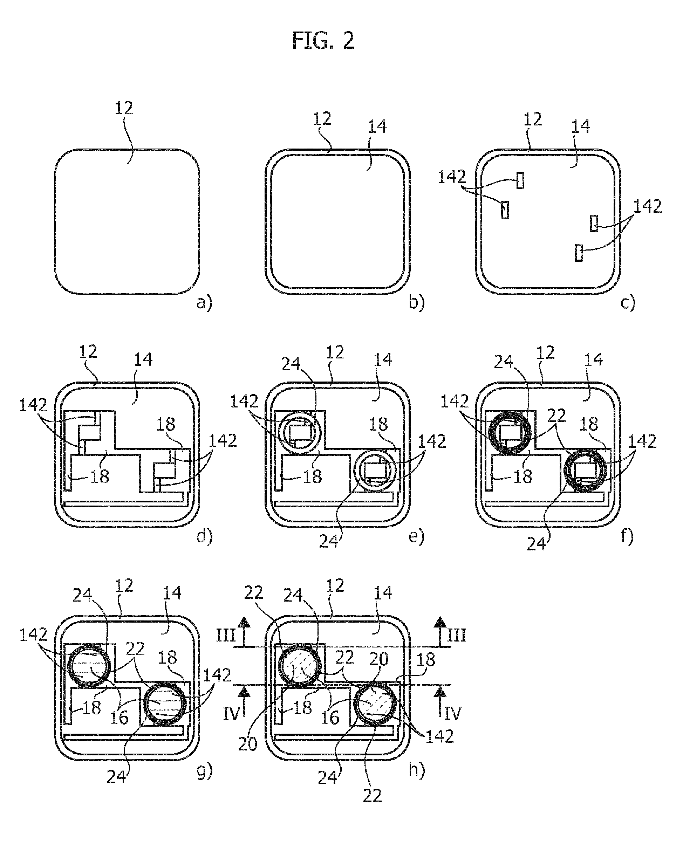

Figure 2 exemplifies, in the sequence of parts denoted as a) to h), steps of a process which, in one or various embodiments, may lead to obtain a device as exemplified in Figure 1 and in Figures 3 to 4, the latter figures being sectional views taken along lines III-III and IV-IV of part h) of Figure 2.

Part b) of Figure 2 exemplifies the formation of the dielectric insulating layer 14 on the front surface 12a of heat sink 12 (which can be seen in part a) of the same Figure 2).

Part c) exemplifies the possibility of providing, on the dielectric layer 14, further electrically isolating elements (pads) 142, having the function of isolating laterally, e.g. in head locations of respective fingers, the electrically conductive, e.g. metallic, lines 18 (respectively anodic and cathodic lines) formed on layer 14, as schematically shown in part d) of Figure 2.

In one or various embodiments, conductive lines 18 may be formed so as to include parts which wrap around the light radiation sources 16. In this way, if they are made of a reflective material (e.g. Ag-based), lines 18 may perform their function of electrical connection, while at the same time contributing to reflect to the outside of device 10 the light radiation emitted by sources 16.

Part e) of Figure 2 shows the formation of a (further) electrically isolating layer 24, which extends above tracks 18 and around sources 16. In the step exemplified in part f) of the same Figure 2, above insulating layer 24 there are formed the side walls 22, which may in turn be made of a material having reflective properties (e.g. an Ag-based material).

In one or various embodiments, as exemplified herein, said side walls 22 (and as a consequence the insulating layer 24 which separates them from conductive tracks 18) are provided with an annular, e.g. circular, arrangement.

In one or various embodiments, walls 22 may form, around each light radiation source 16, a cavity delimited by a reflective peripheral wall, being adapted to project outside device 10 the light radiation emitted by sources 16.

In one or various embodiments, sources 16 may be mounted on the structure of the device, as schematically depicted in part g) of Figure 2, by implementing the power supply connection with lines 18 with standard connection solutions (e.g. bonding).

In one or various embodiments, the lenses 20 (e.g. silicone lenses, possibly with phosphorus filler), may be subsequently deposited within walls 22, i.e. in a location coupled to sources 16.

One or various embodiments, as exemplified in Figures 5 to 7, may comprise parts and elements substantially similar to parts or elements previously described with reference to embodiments exemplified in Figures 1 to 4. The related detailed description will not therefore be repeated in all its aspects, so as not to overburden the present description unnecessarily.

As previously stated, one or various embodiments as exemplified in Figures 5 to 7 may provide one single lens 20, which will be coupled to a plurality of lighting sources 16 (twelve in the presently considered embodiment; this number has of course a merely exemplary value).

As in the case of Figure 2, parts a) and b) of Figure 6 show the provision, on front surface 12a) of heat sink 12, of the insulating dielectric layer 14 on which, in the step depicted in part c) of Figure 6, there are arranged the pads of the additional insulating layer 142 adapted to separate various portions of electrically conductive lines 18, respectively anodic and cathodic, from each other.

In one or various embodiments, as exemplified in Figures 5 to 7, the light radiation sources 16 are adapted to be surrounded by a reflective wall 12, extending along the contour (which is substantially rectangular in the presently considered example, but may have any shape) of the area occupied by the light radiation sources 16; as a consequence, in one or various embodiments, the dielectric insulating layer 24 may be provided (see for instance part e) of Figure 6) only along the contour of that area.

In one or various embodiments, as exemplified in part f) of Figure 6, on top of layer 16 it is then possible to form a peripheral reflective wall 22.

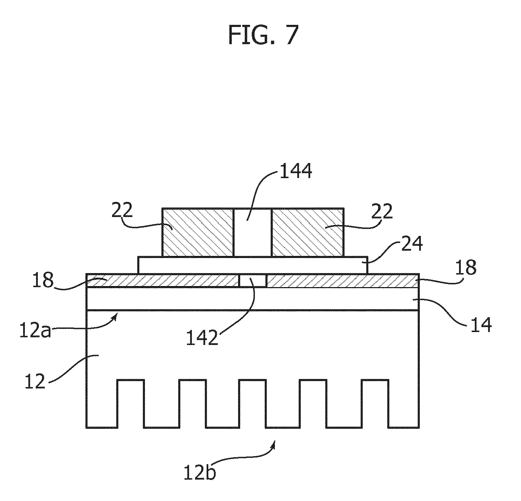

Part g) in Figure 6 shows the possible provision, in one or in various embodiments, of an optional further step, aiming at avoiding the possible occurrence of parasitic conductive paths between the anode and cathode of the CoB structure: to this purpose peripheral wall 22, made of a reflective, e.g. Ag-based, material, which is therefore electrically conductive, may be divided into several neighbouring sections which are mutually isolated by elements (segments) 144 of dielectric insulating material (see also the sectional view in Figure 7) having the function of increasing the discharge distance according to safety standards.

In one or various embodiments, such a step may be omitted, e.g. in the case in which the geometry of the related parts already meets said safety standards by itself

Part h) in Figure 6 exemplifies the arrangement of the light radiation sources (for example LED sources) 16 within the area surrounded by wall 22, implemented by performing the electrical connection of sources 16 with conductive lines 18.

The structure of device 10 is then finished off by the deposition of lens 20, which may be, in one or various embodiments, a silicone lens, for example with a phosphorus filler.

One or various embodiments lead to the achievement of one or several of the following advantages:
- improved thermal management properties, e.g. because the light radiation sources (e.g. LED sources) are attached directly on the heat sink, omitting packages, additional boards and/or thermal interface material;
- improved reliability, thanks to the amelioration of thermal management;
- electrical insulation and safety properties, achievable by changing the thickness and the width of the dielectric layer,
- high flexibility in achieving both distributed and compact LES structures with a specific shape;
- reduced manufacturing costs, thanks to the extended use of the thick-film technology for the manufacturing steps (see for instance Figures 2 to 7).

Of course, without prejudice to the underlying principles of the invention, the details and the embodiments may vary, even appreciably, with respect to what has been described by way of example only, without departing from the extent of protection. Such extent of protection is determined by the annexed claims.

## Claims

1. A solid state lighting device (10), including:
- a heat sink (12) with a front surface (12a),
- an electrically insulating layer (14) on said front surface (12a) of the heat sink (12),
- electrically conductive lines (18) of a reflective material extending over said electrically insulating layer (14),
- at least one solid state light radiation source (16) arranged on said electrically insulating layer (14) and electrically fed via said electrically conductive lines (18), and
- at least one lens formation (20) coupled with said at least one light radiation source (16) by means of a support member including at least one side wall (22) of a reflective material electrically insulated from said electrically conductive lines (18) by a further electrically insulating layer (24).

2. The lighting device of claim 1, wherein said electrically insulating layer (14) and/or said further electrically insulating layer (24) include a dielectric polymer and/or a glassy dielectric material.

3. The lighting device of claim 1 or claim 2, wherein said reflective material includes silver.

4. The lighting device of any of the previous claims, including further electrically insulating formations (142, 144) in at least one of:
- a location interposed between anodic and cathodic electrically conductive lines (18),
- a location interposed between adiacent portions of said at least one side wall (22) of said support member.

5. The lighting device of any of the previous claims, wherein said electrically conductive lines (18) and/or said at least one side wall (22) of said support member extend around said at least one light radiation source (16).

6. The lighting device of any of the previous claims, wherein said at least one side wall (22) of said support member and said at least one further electrically insulating layer (24) have relatively thinner and thicker widths in the direction of the plane of said heat sink (12).

7. The lighting device of any of the previous claims, wherein said at least one lens formation (20) is a silicone lens, preferably including phosphorus as a filler.

8. The lighting device of any of the previous claims, including a plurality of light radiation sources (16) each coupled with a respective lens formation (20).

9. The lighting device of any of claims 1 to 7, including a plurality of light radiation sources (16) with a lens formation (20) coupled with said plurality of light radiation sources (16).

10. The lighting device of any of the previous claims, wherein said at least one light radiation source is a LED source (16), preferably of the CoB type.

11. A method of producing a light radiation source, including:
- providing a heat sink (12) with a front surface (12a),
- forming an electrically insulating layer (14) on said front surface (12a) of the heat sink (12),
- forming electrically conductive lines (18) of a reflective material on said electrically insulating layer (14),
- arranging on said electrically insulating layer (14) at least one solid state light radiation source (16) electrically fed via said electrically conductive lines (18),
- forming at least one side wall (22) of a reflective material electrically insulated from said electrically conductive lines (18) by a further electrically insulating layer (24) to define a support member (22, 24) for coupling at least one lens formation (20) to said at least one light radiation source (16), and
- coupling at least one lens formation (20) with said at least one light radiation source (16) by means of said support member (22, 24).

12. The method of claim 11, wherein said forming steps are by thick-film processes.
